# EUROPÄISCHE PATENTSCHRIFT

(11) **EP 3 824 551 B1**
(45) Veröffentlichungstag und Bekanntmachung des Hinweises auf die Patenterteilung: **07.06.2023**
(21) Anmeldenummer: 19731247.3
(22) Anmeldetag: 13.06.2019
(51) Int. Cl.: H03K 17/082

(54) **SCHALTUNGSVORRICHTUNG SOWIE VERFAHREN ZUM BETRIEB EINER SCHALTUNGSVORRICHTUNG**
CIRCUIT APPARATUS AND METHOD FOR OPERATING A CIRCUIT APPARATUS
DISPOSITIF DE COMMUTATION AINSI QUE PROCÉDÉ POUR FAIRE FONCTIONNER UN DISPOSITIF DE COMMUTATION

(30) Priorität: 17.07.2018 DE 102018211872
(43) Veröffentlichungstag der Anmeldung: 26.05.2021
(73) Patentinhaber: HELLA GmbH & Co. KGaA, 59552 Lippstadt (DE); LEONI Bordnetz-Systeme GmbH, 97318 Kitzingen (DE)
(72) Erfinder: DÖRNBACH, Sebastian, 57339 Erndtebrück (DE); PLASCHKE, Markus, 97080 Würzburg (DE); WAGEMANN, Rolf, 97084 Würzburg (DE)
(74) Vertreter: FDST Patentanwälte
(86) Internationale Anmeldenummer: PCT/EP2019/065603
(87) Internationale Veröffentlichungsnummer: WO 2020/015937

(56) Entgegenhaltungen:
- EP-A2- 2 071 726
- US-A- 5 172 290
- US-A- 5 418 673
- US-A1- 2013 200 929

## Beschreibung

Die Erfindung betrifft eine Schaltungsvorrichtung sowie ein Verfahren zum Betrieb einer derartigen Schaltungsvorrichtung zum sicheren Trennen eines Halbleiterschaltelements.

Halbleiterschalter, insbesondere Transistoren werden heutzutage in nahezu jeder elektronischen Schaltung als elektronische Schaltelemente eingesetzt. Sie haben sich aufgrund ihrer unterschiedlichen Ausgestaltungen z.B. hinsichtlich ihrer Schaltzeiten und/oder ihres Schaltvermögens in Bezug auf eine zu schaltende (elektrische) Leistung als vorteilhaft erwiesen.

Halbleiterschalter sind auch im Kraftfahrzeugbereich, beispielsweise in einem Bordnetz des Kraftfahrzeugs eingesetzt. Üblicherweise sind hierbei FeldeffektTransistoren (FET) und insbesondere Metal-Oxid-Semiconductor-FET (MOSFET) eingesetzt. MOSFETs weisen einen Drain-Anschluss, einen Source-Anschluss sowie einen Gate-Anschluss auf. Mittels des Gate-Anschlusses, insbesondere mittels einer im Betrieb zwischen dem Gate-Anschluss und dem Source-Anschluss anliegenden Spannung (auch als Gate-Spannung bezeichnet), ist ein zwischen dem Drain-Anschluss und dem Source-Anschluss fließender elektrischer Strom steuerbar. D. h. bei einem Überschreiten eines Spannungsschwellwertes der Gate-Spannung, bildet sich ein "Kanal" innerhalb des Halbleitermaterials zwischen dem Drain-Anschluss und dem Source-Anschluss aus und ein elektrischer Strom beginnt zu fließen. Zusätzlich ist es mittels einer Höhe des Wertes der Gate-Spannung ermöglicht, den zwischen Drain- und Source-Anschluss fließenden elektrischen Strom in seinem Wert zu variieren. Grundsätzlich gilt hierbei: Je grö-ßer die Gate-Spannung, desto größer der zwischen Drain-Anschluss und Source-Anschluss fließende Strom. Somit ist mittels eines MOSFETs beispielsweise nicht nur ein (Strom-)Schalter, sondern auch ein (Strom-)Regler realisiert.

In der DE 196 19 467 C2 ist eine Schaltungsanordnung beschrieben, mittels der ein Leistungs-MOSFETs durch eine Anordnung eines zusätzlichen Transistors zischen dem Drain- und dem Gate-Anschluss gegen eine Überspannung am Drain-Anschluss geschützt ist.

In der EP 2 0171 726 A2 wird eine Schaltungsvorrichtung und ein Verfahren nach dem Oberbegriff der Ansprüche 1 und 11 beschrieben.

Ausgehend hiervon liegt der Erfindung die Aufgabe zugrunde, ein zuverlässiges Schalten eines Halbleiterschaltelements zu gewährleisten.

Die Aufgabe wird erfindungsgemäß gelöst durch eine Schaltungsvorrichtung mit den Merkmalen des Anspruchs 1. Vorteilhafte Ausgestaltungen, Weiterbildungen und Varianten sind Gegenstand der Unteransprüche.

Die Schaltungsvorrichtung dient einem sicheren Trennen eines Halbleiterschaltelements, insbesondere eines MOSFETs. Der Halbleiterschalter weist einen Gate-Anschluss (kurz: Gate), einen Source-Anschluss (kurz: Source) sowie einen Drain-Anschluss (kurz: Drain) auf.

Im Betrieb ist mittels des Gates ein Strompfad zwischen Drain und Source reversibel trennbar. Unter reversibel trennbar wird hierbei verstanden, dass der Strompfad zwischen Drain und Source mittels des Gates, insbesondere mittels einer zwischen Gate und Source angelegten Spannung (Gate-Spannung) bei einem Überschreiten eines Spannungsschwellwertes geschlossen wird und bei einem Unterschreiten des Spannungsschwellwertes getrennt wird.

Weiterhin weist der Gate-Anschluss ein Gate-Spannungspotential und der Source-Anschluss ein Source-Spannungspotential auf.

Zwischen dem Gate und der Source ist eine Sicherungseinheit angeordnet. Die Sicherungseinheit ist derart eingerichtet, in Abhängigkeit einer (Spannungs-)Potentialdifferenz zwischen dem Gate-Spannungspotential und dem Source-Spannungspotential nach einem Trennen des Strompfades, also nach einem Abschalten des Halbleiterschalters, das Gate mit der Source elektrisch zu verbinden. Durch diese elektrische Verbindung sind das Gate-Spannungspotential und das Source-Spannungspotential an einen gemeinsamen Wert angeglichen. Vorzugsweise wird hierbei der Wert des Gate-Spannungspotentials von einem Ausgangswert an den Wert des Source-Spannungspotentials angeglichen. Mit anderen Worten wird der Wert des Gate-Spannungspotentials auf den Wert des Source-Spanungspotentials "gezogen".

Der Begriff Potentialdifferenz steht im Sinne dieser Anmeldung gleichbedeutend für eine elektrische Spannung. Die (Spannungs-)Potentialdifferenz entspricht insbesondere der zwischen dem Gate-Anschluss und dem Source-Anschluss angelegten Spannung (Gate-Spannung).

Die Potentialdifferenz, bei welcher das Halbeleiterschaltelement schaltet (also eine leitende Verbindung zwischen dem Drain-Anschluss und der Source ausbildet) hängt unter anderem von dem verwendeten Dotierungsmaterial ab. Beispielsweise liegt die Potentialdifferenz bei siliziumdotierten Halbleiterschaltern üblicherweise bei (betragsmäßig) ca. ≥ 0,7 Volt. Diese Spannung, bzw. diese Potentialdifferenz wird auch als Durchbruchspannung bezeichnet und ist eine durch die Halbleiterdotierung bekannte Kenngröße von Halbleiterschaltelementen.

Durch die elektrische Verbindung zwischen dem Gate-Anschluss und dem Source-Anschluss weisen beide Anschlüsse bevorzugt das gleiche (Spannungs-)Potential oder zumindest weitestgehend das gleiche (Spannungs-)Potential auf. D.h. bei einer nach dem Abschalten des Halbleiterschalters auftretenden Potentialdifferenz, insbesondere durch ein durch eine Eigeninduktivität der Leitung bedingtes negatives Source-Spannungspotential, wird diese Potentialdifferenz - negatives Source-Potential zu Gate-Potential - durch das elektrische Verbinden des Gates mit der Source angeglichen. Somit ist ein erneutes ungewolltes Schalten des Halbleiterschaltelements verhindert. Unter Angleichen wird hierbei verstanden, dass die beiden Spannungspotentiale im Wesentlichen den gleichen Wert aufweisen. Unter im Wesentlichen wird hierbei eine Spannungsdifferenz der beiden Spannungspotentiale nach der Angleichung von beispielsweise <0,5V, insbesondere von <0,2V verstanden.

Diese Ausgestaltung beruht auf der Überlegung, dass bei Schaltvorgängen, insbesondere bei Abschaltvorgängen von MOSFETs innerhalb einer Schaltung, beispielsweise innerhalb eines Bordnetzes eines Kraftfahrzeuges, am Drain- und Source-Anschluss (zusätzliche) Spannungspotentiale in Form von Spannungsspitzen entstehen. Derartige unterschiedliche Spannungspotentiale werden durch Eigeninduktivitäten der an den jeweiligen Anschlüssen angeordneten Leitungen hervorgerufen.

Üblicherweise stellt sich am Drain-Anschluss ein positives Spannungspotential und am Source-Anschluss ein negatives Spannungspotential ein. Weist hierbei das Spannungspotential am Source-Anschluss einen negativeren Wert auf, als ein für den Abschaltvorgang eingestelltes Gate-Potential (meist ein Massepotential, also 0V), droht ein erneutes - meist ungewolltes - (An-)schalten des MOSFET. Dies beruht darauf, dass durch das in Bezug auf das Gate-Potential negativere Spannungspotential am Source-Anschluss betragsmäßig der Spannungsschwellwert der Gate-Spannung überschritten wird.

Dies kann zu einer Überlastung und folglich zu einem Ausfall des MOSFETs führen.

Gemäß einer bevorzugten Ausgestaltung weist die Sicherungseinheit einen Transistor, insbesondere einen Bipolartransistor auf. Der Transistor weist einen basisseitigen Basis-Anschluss, einen emitterseitigen Emitter-Anschluss sowie einen kollektorseitigen Kollektor-Anschluss auf. Hierdurch wird eine von der (Span-nungs-)Potentialdifferenz abhängige Ausbildung der elektrischen Verbindung zwischen dem Gate und der Source ermöglicht. D.h., dass das Sicherungselement, insbesondere der Transistor, ab dem für das Schalten des Halbleiterschaltelements notwendigen Potentialdifferenz (z.B. 0,7 Volt) in den leitenden Zustand schaltet und somit den Gate-Anschluss und den Source-Anschluss des Halbleiterschaltelements verbindet. Hierdurch wird die Potentialdifferenz angeglichen, sodass das Halbleiterschaltelement nicht schaltet.

Gemäß einer bevorzugten Ausgestaltung ist der Transistor emitterseitig mit dem Source-Anschluss und kollektorseitig mit dem Gate-Anschluss des Halbleiterschaltelements verbunden. Hierdurch ist eine elektrisch leitende Verbindung zwischen dem Gate-Anschluss und dem Source-Anschluss des Halbleiterschaltelements realisiert, welche durch den Transistor leitend und sperrend geschaltet werden kann. Vorzugsweise sind zwischen dem Emitter des Transistors und dem Source-Anschluss des Halbleiterschaltelements keine weiteren Elemente angeordnet, d.h. der Transistor ist emitterseitig unmittelbar mit dem Source-Anschluss des Halbleiterschaltelements verbunden. Jedoch lässt sich diese Schaltung, insbesondere die elektrisch leitendende Verbindung zwischen dem Emitter des Transistors und dem Source-Anschluss des Halbleiterschalters auch unter einer anderen Anordnung realisieren. D.h., dass beispielsweise eine unmittelbare Anbindung zwischen dem Emitter und dem Source-Anschluss nicht zwingend notwendig ist und somit alternativ auch eine mittelbare Verbindung zwischen dem Emitter und des Source-Anschluss ausgebildet sein kann. Unter der mittelbaren Verbindung wird hierbei eine elektrische Verbindung verstanden, bei der zwischen dem Emitter und dem Source-Anschluss noch zumindest ein weiteres elektrisches oder elektronisches Bauteil angeordnet ist.

Zweckdienlicherweise ist der Transistor basisseitig mit einem Massepotential verbunden. Bevorzugt handelt es sich bei dem Massepotential um das gleiche Massepotential, an das der Source-Anschluss des Halbleiterschaltelements mittelbar oder unmittelbar angeschlossen ist.

Der Transistor ist somit nach Art einer Basisschaltung innerhalb der Sicherungseinheit angeordnet und verschaltet.

Zweckdienlicherweise weist die Sicherungseinheit ein Widerstandselement, z.B. einen ohmschen Widerstand zur Strombegrenzung auf. Das Widerstandselement ist hierzu vorzugsweise kollektorseitig dem Kollektoranschluss vorgeschaltet.

Zudem weist die Sicherungseinheit bevorzugt ein Bauelement auf, welches derart eingerichtet ist, einen unidirektionalen Stromfluss zwischen dem Gate-Anschluss und dem Kollektor-Anschluss auszubilden und insbesondere zu realisieren. Bei dem Bauelement kann es sich im einfachsten Fall um ein einzelnes elektrisches oder elektronisches Bauteil handeln. Alternativ weist das Bauteil mehrere Bauteile auf oder ist aus mehreren Bauteilen gebildet, die schaltungstechnisch derart miteinander verbunden sind, den unidirektionalen Stromfluss auszubilden. Unter dem unidirektionalen Stromfluss wird hierbei ein Stromfluss in lediglich eine Richtung entlang eines Strompfades verstanden.

Bevorzugt realisiert das Bauelement einen unidirektionalen Stromfluss von dem Gate-Anschluss zu dem Kollektor-Anschluss. Mit anderen Worten sperrt das Bauteil einen Stromfluss von dem Kollektor-Anschluss zu dem Gate-Anschluss. Hierdurch wird verhindert, dass das Gate-Potential im ausgeschalteten Zustand des Halbleiterschaltelements (also im nichtleitenden Zustand) durch das Source-Spannungspotential angehoben wird und das Halbleiterschaltelement einschaltet.

Bevorzugt ist das Bauelement mit dem Gate-Anschluss des Halbleiterschalters verbunden, vorzugsweise ohne dass weitere Elemente zwischen dem Gate-Anschluss und der Diode geschaltet sind. Das Widerstandselement ist vorzugsweise zwischen dem Bauelement und dem Kollektor-Anschluss des Transistors angeordnet.

Gemäß einer bevorzugten Ausgestaltung handelt es sich bei dem Bauelement um eine Diode, die in Sperrrichtung zum Gate-Anschluss verschaltet ist, also einen Stromfluss zum Gate-Anschluss hin sperrt. Grundsätzlich sind alle Halbleiterbauelemente, die einen unidirektionalen Stromfluss ausbilden können, zur Ausbildung des Bauelements denkbar. Ein unidirektionaler Stromfluss kann alternativ auch durch ein Verschalten eines Halbleiterbauelements unmittelbar nach dem Emitter ausgebildet werden.

Zusammen mit dem emitterseitigen Anschluss des Transistors an den Source-Anschluss wird hierdurch erreicht, dass bei einem anliegenden negativen Source-Potential, welches unter Umständen zu einer den Halbleiterschalter schaltenden Potentialdifferenz führt, diese Potentialdifferenz auch an dem Transistor anliegt, vorzugsweise zwischen dem am Massepotential angeschlossenen Basis-Anschluss und dem an dem Source-Anschluss angeschlossenen Emitter-Anschluss. Hierdurch schaltet der Transistor den leitenden Zustand und verbindet den Gate-Anschluss mit dem Source-Anschluss, bevor aufgrund der Potentialdifferenz der Halbleiterschalter erneut (ungewollt) schaltet. Vorzugsweise entspricht hierbei die Durchbruchspannung des Transistors der Durchbruchspannung des Halbleiterschaltements.

Zum Schutz vor einer Überspannung zwischen dem Gate-Anschluss und dem Source-Anschluss, ist parallel zu der Sicherungseinheit ein Überspannungsschutzelement zwischen dem Gate-Anschluss und dem Source-Anschluss des Halbleiterschaltelementes angeordnet. Das Überspannungsschutzelement kann hierbei Teil der Sicherungseinheit sein.

Das Überspannungsschutzelement weist gemäß einer bevorzugten Ausgestaltung zwei gegensinnig geschaltete Schutzdioden auf. Bei den beiden Dioden handelt es sich beispielsweise um Suppressordioden.

Bevorzugt ist die Schaltungsvorrichtung in einem Kraftfahrzeug angeordnet. Insbesondere ist die Schaltungsvorrichtung zum sicheren Trennen eines Halbleiterschalters ausgebildet, der im Bordnetz eines derartigen Kraftfahrzeuges angeordnet ist. Alternativ kann die Schaltungsvorrichtung jedoch, ohne Beschränkung eines technischen Gebiets, zum Schutz von Halbleiterschalter im Allgemeinen eingesetzt werden.

Das Halbleiterschaltelement ist bevorzugt zum Schalten eines Verbrauchers in einem Kraftfahrzeug und insbesondere als ein Leistungs-Halbleiterschaltelement ausgebildet und z.B. geeignet zum Schalten von elektrischen Strömen mit Werten im Bereich von vorzugsweise >1A und insbesondere von >10A.

Die auf das Verfahren gerichtete Aufgabe wird erfindungsgemäß gelöst durch ein Verfahren zum Betrieb einer Schaltungsvorrichtung mit den Merkmalen des Anspruchs 11.

Bei der Schaltungsvorrichtung handelt es sich insbesondere um die bereits vorstehend beschriebene Schaltungsvorrichtung.

Die im Hinblick auf die Schaltungsvorrichtung aufgeführten Vorteile und bevorzugten Ausgestaltungen sind sinngemäß auf das Verfahren zu übertragen und umgekehrt.

Ein Ausführungsbeispiel der Erfindung ist nachfolgend anhand der Figur näher erläutert. Diese zeigt in vereinfachter Darstellung:

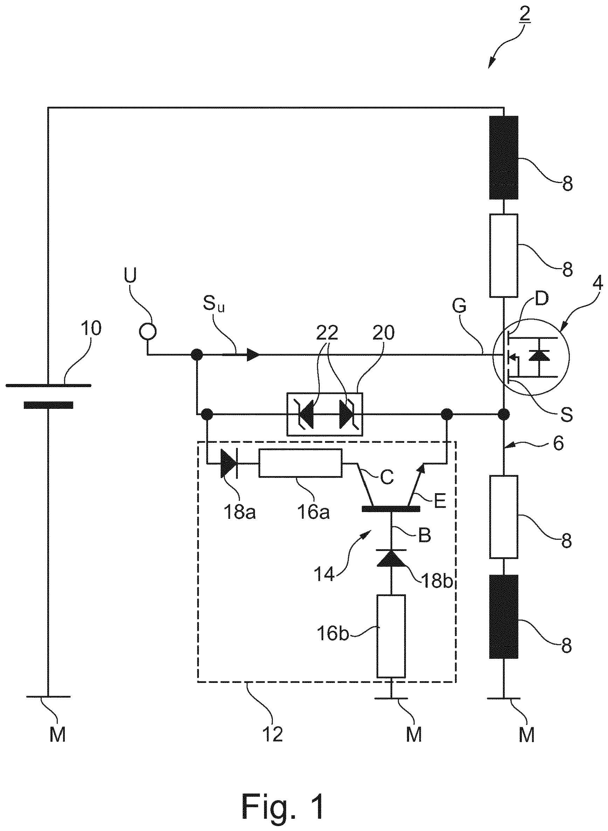

Fig. 1 ein Schaltbild einer Schaltungsvorrichtung zum sicheren Trennen eines Halbleiterschalters.

Die in Fig. 1 gezeigte Schaltungsvorrichtung 2 ist insbesondere als eine Schaltungsvorrichtung 2 für ein Bordnetz eines Kraftfahrzeuges (nicht dargestellt) ausgebildet.

Die Schaltungsvorrichtung 2 dient einem sicheren Abschalten eines Halbleiterschaltelements 4. Das Halbeleiterschaltelement 4 ist im Ausführungsbeispiel als ein MOSFET ausgebildet mit einem Gate-Anschluss G, einem Source-Anschluss S sowie mit einem Drain-Anschluss D. Im Betrieb ist mittels des Halbleiterschaltelements 4 ein Strompfad 6 reversibel trennbar. Hierzu ist das Halbleiterschaltelement 4 mit dem Drain-Anschluss D und dem Source-Anschluss S an den Strompfad 6 angeschlossen. Im Ausführungsbeispiel ist der Source-Anschluss S zudem an ein Massepotential M angeschlossen. Über den Strompfad 6 sind elektrische Verbraucher 8 mit einer Spannungsquelle 10, beispielsweise einer Batterie des Kraftfahrzeuges verbunden und werden hierdurch im Betrieb mit elektrischer Leistung versorgt. Die Spannungsquelle 10 weist eine Betriebsspannung mit einem Wert im Bereich von 10V bis 50V auf.

Bei dem Halbleiterschaltelement 4 handelt es sich um ein spannungsgesteuertes Halbleiterschaltelement 4, sodass mittels einer angelegten Spannung das Halbleiterschaltelement 4 an- bzw. abgeschaltet, also leitend bzw. sperrend geschaltet werden kann.

Hierzu wird ein Steuersignal S_{U} in Form einer elektrischen Spannung U an den Gate-Anschluss G angelegt, sodass die Spannung U zwischen dem Gate-Anschluss G und dem Source-Anschluss S anliegt. Übersteigt die angelegte Spannung U eine dotierungsabhängig vorgegebenen Spannungsschwellwert, so schaltet das Halbleiterelement 4 in einen leitenden Zustand, sodass zwischen dem Drain-Anschluss D und dem Source-Anschluss S ein elektrischer Strom fließen kann. Mit anderen Worten ist mittels des Gate-Anschlusses G die Strecke zwischen Drain-Anschluss D und Source-Anschluss S leitend oder sperrend schaltbar. Beispielsweise weist der Spannungsschwellwert bei einem siliziumdotierten Halbleiterschaltelement einen Wert von ca. 0,7 Volt auf, sodass ab eine "Gate-Source-Spannung" (auch lediglich als Gate-Spannung bezeichnet) von ca. 0,7 Volt das Halbleiterschaltelement 4 in den leitenden Zustand schaltet.

Weiterhin weist der Gate-Anschluss G sowie der Source-Anschluss S im Betrieb ein Gate-Spannungspotential U_{G} beziehungsweise ein Source-Spannungspotential U_{S} auf.

Insbesondere beim Trennen des Strompfades 6, also beim Abschalten des Halbleiterschaltelements 4 treten aufgrund von Eigeninduktivitäten des Leitermaterials des Strompfades 6 unterschiedliche (, zusätzliche) Spannungsspitzen an den Anschlüssen D,G,S des Halbleiterschaltelements 4 auf, insbesondere am Drain-Anschluss D und am Source-Anschluss S.

Üblicherweise stellt sich durch diese Spannungsspitzen am Source-Anschluss S ein negatives Spanungspotential ein. Am Drain-Anschluss D stellt sich aufgrund der Spannungsspitzen üblicherweise ein positives Spannungspotential ein.

Übersteigt das negative Spannungspotential des Source-Anschlusses S betragsmäßig den Spannungsschwellwert, der für das Schalten des Halbleiterschaltelements 4 notwendig ist (z.B. 0,7 Volt), so schaltet das Halbleiterschaltelement 4 erneut, ungewollt, in den leitenden Zustand. Mit anderen Worten: Wird das Source-Spannungspotential U_{S} aufgrund der Spannungsspitzen um beispielsweise mindestens 0,7 Volt "negativer" als das Gate-Spannungspotential U_{G}, so wird (betragsmäßig) der Spannungsschwellwert zum Durchschalten des Halbleiterschaltelements 4 erreicht oder überschritten und das Halbleiterschaltelement 4 schaltet erneut in den leitenden Zustand.

Ein derartiges erneutes, ungewolltes Schalten kann zu einer Beschädigung oder einer Zerstörung des Halbleiterschaltelements 4 führen.

Um ein derartiges Wiedereinschalten des Halbleiterschaltelements 4 zu verhindern, weist die Schaltungsvorrichtung 2 eine Sicherungseinheit 12 auf. Die Sicherungseinheit 12 ist derart eingerichtet, in Abhängigkeit einer (Spannungs-)Potentialdifferenz ΔU zwischen dem Gate-Anschluss G und dem Source-Anschluss S nach dem Trennen (Schalten in den sperrenden Zustand) des Halbleiterschaltelements 4 den Gate-Anschluss G mit dem Source-Anschluss S elektrisch zu verbinden. Hierdurch wird das Gate-Spannungspotential U_{G} an das Source-Spannungspotential U_{S} angeglichen, sodass der Spannungsschwellwert zum Schalten des Halbleiterschaltelements 4 nicht erreicht wird und das Halbleiterschaltelement 4 im sperrenden (ausgeschalteten) Zustand bleibt. Zweckdienlicherweise entspricht die (Spannungs-)Potentialdifferenz ΔU dem Spannungsschwellwert.

Die Sicherungseinheit 12 weist einen Transistor 14, insbesondere einen Bipolartransistor auf mit einem basisseitigen Basis-Anschluss B, mit einem emitterseitigen Emitter-Anschluss E sowie mit einem kollektorseitigen Kollektor-Anschluss C.

Der Transistor 14 ist kollektorseitig an den Gate-Anschluss G des Halbleiterschaltelements 4 angeschlossen. Emitterseitig ist der Transistor 14 an den Source-Anschluss S des Halbleiterschaltelements 4 angeschlossen. Der Transistor 14 bildet somit im Ausführungsbeispiel im Wesentlichen die eigentliche elektrische Verbindung zwischen dem Gate-Anschluss G und dem Source-Anschluss S aus. Durch die Schalterfunktion des Transistors 14 ist weiterhin diese elektrische Verbindung reversibel trennbar, sodass der Gate-Anschluss G und der Source-Anschluss S nicht dauerhaft verbunden sind. D.h. vorzugsweise lediglich nach einem Abschalten und bei einem Überschreiten des Spannungsschwellwertes durch die (Spannungs-)Potentialdifferenz ΔU schaltet der Transistor 14 in den leitenden Zustand und verbindet den Gate-Anschluss G mit dem Source-Anschluss S.

An den Kollektor-Anschluss C des Transistors 14 ist ein Widerstandselement 16a zur Strombegrenzung angeschlossen. Zudem ist seriell zum Widerstandselement 16a ein - im Ausführungsbeispiel - als Diode ausgebildetes Bauelement 18a kollektorseitig an den Transistor 14 angeschlossen. Im Ausführungsbeispiel sind das Widerstandselement 16a und das Bauelement 18a Teil der Sicherungseinheit 12.

Weiterhin ist der Transistor 14 basisseitig an das Massepotential M angeschlossen. Im Ausführungsbeispiel sind weiterhin ein Widerstandselement 16b sowie eine - in Reihe zu dem Widerstandselement 16b geschaltete - Diode 18b an den Basis-Anschluss B des Transistors 14 angeschlossen. Vorzugsweise sind weiterhin keine weiteren Elemente als die vorgenannten Elemente 16b, 18b zwischen dem Basis-Anschluss B und dem Massepotential M angeordnet.

Durch die Verschaltung des Transistors 14 mit dem Basis-Anschluss B an das Massepotential M und mit dem Emitter-Anschluss E an den Source-Anschluss S wird das Schalten des Transistors 14 gesteuert. Hierzu wird das eigentlich zu vermeidende negative Spannungspotential des Source-Anschlusses S nach dem Abschalten des Halbleiterschaltelements 4 ausgenutzt. Dieses negative Spannungspotential liegt aufgrund der Verschaltung auch am Emitter-Anschluss E an. Um durchzuschalten, also in den leitenden Zustand zu schalten, benötigt der Transistor 14 einen Strom, der von dem Basis-Anschluss B zum Emitter-Anschluss E fließt. Dieser Strom fließt beispielsweise bei siliziumdotierten Bipolartransistoren, wenn eine Spannungsdifferenz mit einem Wert im Bereich von ca. 0,7 Volt zwischen dem Basis-Anschluss B und dem Emitter-Anschluss E auftritt (auch als Basis-Emitter-Spannung bezeichnet).

Der Transistor 14 schaltet somit, grob vereinfacht ausgedrückt, dann durch, sobald das Spannungspotential des Emitter-Anschlusses E und somit auch das Source-Spannungspotential U_{S} mindestens um den Wert der Spannungsdifferenz, welche zum Schalten des Transistors 14 benötigt wird "negativer" ist, als das Spannungspotential des Basis-Anschlusses B. Hierdurch ist (betragsmäßig) die notwendige Spannungsdifferenz, im Beispiel des siliziumdotierten Transistors 0,7 Volt, erreicht, im Details betrachtet schaltet der Transistor 14 - gemäß der zweiten Kirchhoff'schen Regel-, wenn das Source-Spannungspotential Us niedriger, also negativer, als das Massepotential M abzüglich eines Spannungsabfalls über der Diode 18b und der Basis-Emitter-Spannung ist.

Bevorzugt ist der Transistor 14 derart ausgelegt, dass sich die Spannungsdifferenz, bei der der Transistor 14 in den leitenden Zustand schaltet und der Spannungsschwellwert, bei dem das Halbleiterschaltelement 4 in den leitenden Zustand schaltet entsprechen.

Zum Überspannungsschutz ist parallel zu der Sicherungseinheit 12 ein Überspannungsschutzelement 20 angeordnet. Das Überspannungsschutzelement 20 weist zwei bidirektional verschaltete Schutzdioden 22, beispielsweise Suppressordioden auf. Alternativ ist das Überspannungsschutzelement 20 ebenfalls Teil der Sicherungseinheit 12.

### Bezugszeichenliste

- 2: Schaltungsvorrichtung
- 4: Halbleiterschaltelement
- 6: Strompfad
- 8: Verbraucher
- 10: Spannungsquelle
- 12: Sicherungseinheit
- 14: Transistor
- 16a,b: Widerstandselement
- 18a,b: Bauelement
- 20: Überspannungsschutzelement
- 22: Schutzdiode

- B: Basis-Anschluss
- C: Kollektor-Anschluss
- D: Drain-Anschluss
- E: Emitter-Anschluss
- G: Gate-Anschluss
- S: Source-Anschluss
- S_{U}: Steuersignal
- M: Massepotential
- U: elektrische Spannung
- U_{G}: Gate-Spannungspotential
- U_{S}: Source-Spannungspotential
- ΔU: Spannungspotentialdifferenz

## Patentansprüche

1. Schaltungsvorrichtung (2) zum sicheren Trennen eines Halbleiterschaltelements (4), insbesondere eines MOSFET, wobei
- das Halbleiterschaltelement (4) einen Gate-Anschluss (G), einen Source-Anschluss (S) sowie einen Drain-Anschluss (D) aufweist, wobei im Betrieb des Halbleiterschaltelements (4) mittels des Gate-Anschlusses (G) ein Strompfad (6) zwischen dem Drain-Anschluss (D) und dem Source-Anschluss (S) reversibel trennbar ist und
- der Gate-Anschluss (G) ein Gate-Spannungspotential (U_{G}) aufweist und der Source-Anschluss (S) ein Source-Spannungspotential (U_{S}) aufweist,
- wobei zwischen dem Gate-Anschluss (G) und dem Source-Anschluss (S) eine Sicherungseinheit (12) angeordnet ist
**dadurch gekennzeichnet,**
- **dass** die Sicherungseinheit (12) derart eingerichtet und ausgebildet ist, in Abhängigkeit einer Spannungspotentialdifferenz (ΔU) zwischen dem Gate-Spannungspotential (U_{G}) und dem Source-Spannungspotential (U_{S}) nach einem Trennen des Strompfades (6) den Gate-Anschluss (G) mit dem Source-Anschluss (S) elektrisch zu verbinden, sodass das Gate-Spannungspotential (U_{G}) und das Source-Spannungspotential (U_{S}) angeglichen sind.

2. Schaltungsvorrichtung (2) nach dem vorhergehenden Anspruch,
**dadurch gekennzeichnet,**
**dass** die Sicherungseinheit (12) einen Transistor (14), insbesondere einen Bipolartransistor mit einem basisseitigen Basis-Anschluss (B), mit einem emitterseitigen Emitter-Anschluss (E) sowie mit einem kollektorseitigen Kollektor-Anschluss (C) aufweist.

3. Schaltungsvorrichtung (2) nach einem der vorhergehenden Ansprüche,
**dadurch gekennzeichnet,**
**dass** der Transistor (14) emitterseitig mit dem Source-Anschluss (S) des Halbleiterschaltelements (4) und kollektorseitig mit dem Gate-Anschluss (G) des Halbeleiterschaltelements (4) verbunden ist.

4. Schaltungsvorrichtung (2) nach einem der beiden vorhergehenden Ansprüche,
**dadurch gekennzeichnet,**
**dass** der Transistor (14) basisseitig mit einem Massepotential (M) verbunden ist.

5. Schaltungsvorrichtung (2) nach einem der vorhergehenden Ansprüche,
**dadurch gekennzeichnet,**
**dass** die Sicherungseinheit (12) ein Widerstandselement (16a) aufweist.

6. Schaltungsvorrichtung (2) nach einem der vorhergehenden Ansprüche,
**dadurch gekennzeichnet,**
**dass** die Sicherungseinheit (12) ein Bauelement (18a) aufweist, welches derart eingerichtet ist, einen unidirektionalen Stromfluss zwischen dem Gate-Anschluss (G) und dem Kollektor-Anschluss (C) auszubilden.

7. Schaltungsvorrichtung (2) nach dem vorhergehenden Anspruch,
**dadurch gekennzeichnet,**
**dass** das Bauelement (18a) als eine Diode ausgebildet ist.

8. Schaltungsvorrichtung (2) nach einem der vorhergehenden Ansprüche,
**dadurch gekennzeichnet,**
**dass** parallel zu der Sicherungseinheit (12) ein Überspannungsschutzelement (20) zwischen dem Gate-Anschluss (G) und dem Source-Anschluss (S) des Halbleiterschaltelements (4) geschaltet ist.

9. Schaltungsvorrichtung (2) nach dem vorhergehenden Anspruch,
**dadurch gekennzeichnet,**
**dass** das Überspannungsschutzelement (20) zwei gegensinnig geschaltete Schutzdioden (22) aufweist.

10. Schaltungsvorrichtung (2) nach einem der vorgehenden Ansprüche, die in einem Kraftfahrzeug angeordnet ist.

11. Verfahren zum Betrieb einer Schaltungsvorrichtung (2) zum sicheren Trennen eines Halbleiterschaltelements (4), insbesondere eines MOSFET, wobei
- das Halbleiterschaltelement (4) einen Gate-Anschluss (G), einen Source-Anschluss (S) sowie einen Drain-Anschluss (D) aufweist, wobei mittels des Gate-Anschlusses (G) ein Strompfad (6) zwischen dem Drain-Anschluss (D) und dem Source-Anschluss (S) reversibel getrennt wird und
- der Gate-Anschluss (G) ein Gate-Spannungspotential (U_{G}) aufweist und der Source-Anschluss (S) ein Source-Spannungspotential (U_{S}) aufweist,
- wobei zwischen dem Gate-Anschluss (G) und dem Source-Anschluss (S) eine Sicherungseinheit (12) angeordnet ist
**dadurch gekennzeichnet,**
- **dass** mittels der Sicherungseinheit (12) in Abhängigkeit einer Spannungspotentialdifferenz (ΔU) zwischen dem Gate-Spannungspotential (U_{G}) und dem Source-Spannungspotential (U_{S}) nach einem Trennen des Strompfades (6) der Gate-Anschluss (G) mit dem Source-Anschluss (S) elektrisch verbunden wird, sodass das Gate-Spannungspotential (U_{G}) und das Source-Spannungspotential (U_{S}) angeglichen werden.

## Claims

1. Circuit device (2) for safely disconnecting a semiconductor switching element (4), in particular a MOSFET, wherein
- the semiconductor switching element (4) has a gate terminal (G), a source terminal (S) and a drain terminal (D), wherein a current path (6) between the drain terminal (D) and the source terminal (S) is reversibly disconnectable by means of the gate terminal (G) during operation of the semiconductor switching element (4), and
- the gate terminal (G) has a gate voltage potential (U_{G}) and the source terminal (S) has a source voltage potential (U_{S}),
- wherein
a fuse unit (12) is arranged between the gate terminal (G) and the source terminal (S),
**characterized**
- **in that** the fuse unit (12) is configured and designed to electrically connect the gate terminal (G) to the source terminal (S) depending on a voltage potential difference (ΔU) between the gate voltage potential (U_{G}) and the source voltage potential (U_{S}) after disconnection of the current path (6), such that the gate voltage potential (U_{G}) and the source voltage potential (U_{S}) are matched.

2. Circuit device (2) according to the preceding claim,
**characterized**
**in that** the fuse unit (12) comprises a transistor (14), in particular a bipolar transistor having a base terminal (B) on the base side, having an emitter terminal (E) on the emitter side, and having a collector terminal (C) on the collector side.

3. Circuit device (2) according to either of the preceding claims,
**characterized**
**in that** the transistor (14) is connected to the source terminal (S) of the semiconductor switching element (4) on the emitter side and to the gate terminal (G) of the semiconductor switching element (4) on the collector side.

4. Circuit device (2) according to either of the two preceding claims,
**characterized**
**in that** the transistor (14) is connected to an earth potential (M) on the base side.

5. Circuit device (2) according to any of the preceding claims,
**characterized**
**in that** the fuse unit (12) comprises a resistance element (16a).

6. Circuit device (2) according to any of the preceding claims,
**characterized**
**in that** the fuse unit (12) comprises a component (18a) configured in such a way as to form a unidirectional current flow between the gate terminal (G) and the collector terminal (C).

7. Circuit device (2) according to the preceding claim, **characterized**
**in that** the component (18a) is embodied as a diode.

8. Circuit device (2) according to any of the preceding claims,
**characterized**
**in that** an overvoltage protection element (20) is connected in parallel with the fuse unit (12) between the gate terminal (G) and the source terminal (S) of the semiconductor switching element (4).

9. Circuit device (2) according to the preceding claim,
**characterized**
**in that** the overvoltage protection element (20) comprises two protection diodes (22) connected in opposite directions.

10. Circuit device (2) according to any of the preceding claims, which is arranged in a motor vehicle.

11. Method for operating a circuit device (2) for safely disconnecting a semiconductor switching element (4), in particular a MOSFET, wherein
- the semiconductor switching element (4) has a gate terminal (G), a source terminal (S) and a drain terminal (D), wherein a current path (6) between the drain terminal (D) and the source terminal (S) is reversibly disconnected by means of the gate terminal (G), and
- the gate terminal (G) has a gate voltage potential (U_{G}) and the source terminal (S) has a source voltage potential (U_{S}),
- wherein
a fuse unit (12) is arranged between the gate terminal (G) and the source terminal (S),
**characterized**
- **in that** the gate terminal (G) is electrically connected to the source terminal (S) by means of the fuse unit (12) depending on a voltage potential difference (ΔU) between the gate voltage potential (U_{G}) and the source voltage potential (U_{S}) after disconnection of the current path (6), such that the gate voltage potential (U_{G}) and the source voltage potential (U_{S}) are matched.

## Revendications

1. Dispositif de commutation (2) destiné à déconnecter de manière sécurisée un élément de commutation semiconducteur (4), notamment un MOSFET,
- l'élément de commutation semiconducteur (4) possédant une borne de gâchette (G), une borne de source (S) ainsi qu'une borne de drain (D), en fonctionnement de l'élément de commutation semiconducteur (4), un trajet de courant (6) entre la borne de drain (D) et la borne de source (S) pouvant être déconnecté de manière réversible au moyen de la borne de gâchette (G) et
- la borne de gâchette (G) possédant un potentiel de tension de gâchette (U_{G}) et la borne de source (S) possédant un potentiel de tension de source (U_{S}),
- une unité de sécurité (12) étant disposée entre la borne de gâchette (G) et la borne de source (S), **caractérisé en ce**
- **que** l'unité de sécurité (12) est conçue et configurée de manière à relier électriquement la borne de gâchette (G) à la borne de source (S) en fonction d'une différence de potentiel de tension (ΔU) entre le potentiel de tension de gâchette (U_{G}) et le potentiel de tension de source (U_{S}) après une déconnexion du trajet de courant (6), de sorte que le potentiel de tension de gâchette (U_{G}) et le potentiel de tension de source (U_{S}) soient équilibrés.

2. Dispositif de commutation (2) selon la revendication précédente, **caractérisé en ce que** l'unité de sécurité (12) possède un transistor (14), notamment un transistor bipolaire comprenant une borne de base (B) côté base, comprenant une borne d'émetteur (E) côté émetteur et comprenant aussi une borne de collecteur (C) côté collecteur.

3. Dispositif de commutation (2) selon l'une des revendications précédentes, **caractérisé en ce que** le transistor (14) est relié du côté émetteur à la borne de source (S) de l'élément de commutation semiconducteur (4) et du côté collecteur à la borne de gâchette (G) de l'élément de commutation semiconducteur (4).

4. Dispositif de commutation (2) selon l'une des deux revendications précédentes, **caractérisé en ce que** le transistor (14) est relié du côté base à un potentiel de masse (M).

5. Dispositif de commutation (2) selon l'une des revendications précédentes, **caractérisé en ce que** l'unité de sécurité (12) possède un élément résistif (16a).

6. Dispositif de commutation (2) selon l'une des revendications précédentes, **caractérisé en ce que** l'unité de sécurité (12) possède un composant (18a) qui est conçu de manière à former un flux de courant unidirectionnel entre la borne de gâchette (G) et la borne de collecteur (C) .

7. Dispositif de commutation (2) selon l'une des revendications précédentes, **caractérisé en ce que** le composant (18a) est réalisé sous la forme d'une diode.

8. Dispositif de commutation (2) selon l'une des revendications précédentes, **caractérisé en ce qu'**un élément de protection contre les surtensions (20) est branché entre la borne de gâchette (G) et la borne de source (S) de l'élément de commutation semiconducteur (4) en parallèle avec l'unité de sécurité (12).

9. Dispositif de commutation (2) selon l'une des revendications précédentes, **caractérisé en ce que** l'élément de protection contre les surtensions (20) possède deux diodes de protection (22) branchées en têtebêche.

10. Dispositif de commutation (2) selon l'une des revendications précédentes, lequel est disposé dans un véhicule automobile.

11. Procédé pour faire fonctionner un dispositif de commutation (2) destiné à déconnecter de manière sécurisée un élément de commutation semiconducteur (4), notamment un MOSFET,
- l'élément de commutation semiconducteur (4) possédant une borne de gâchette (G), une borne de source (S) ainsi qu'une borne de drain (D), un trajet de courant (6) entre la borne de drain (D) et la borne de source (S) pouvant être déconnecté de manière réversible au moyen de la borne de gâchette (G) et
- la borne de gâchette (G) possédant un potentiel de tension de gâchette (U_{G}) et la borne de source (S) possédant un potentiel de tension de source (U_{S}),
- une unité de sécurité (12) étant disposée entre la borne de gâchette (G) et la borne de source (S), **caractérisé en ce**
- **que** la borne de gâchette (G) est reliée électriquement à la borne de source (S) au moyen de l'unité de sécurité (12) en fonction d'une différence de potentiel de tension (ΔU) entre le potentiel de tension de gâchette (U_{G}) et le potentiel de tension de source (U_{S}) après une déconnexion du trajet de courant (6), de sorte que le potentiel de tension de gâchette (U_{G}) et le potentiel de tension de source (U_{S}) soient équilibrés.
